**Europäisches Patentamt**

**European Patent Office**

**Office européen des brevets**

(19)

(11) Veröffentlichungsnummer: **0 246 419 B1**

## (12) EUROPÄISCHE PATENTSCHRIFT

(45) Veröffentlichungstag der Patentschrift: **10.04.91**

(51) Int. Cl.⁵: **G01R 33/035**

(21) Anmeldenummer: **87104110.9**

(22) Anmeldetag: **20.03.87**

(54) **SQUID-Magnetometer für eine Vorrichtung zur Messung schwacher Magnetfelder.**

(30) Priorität: **21.05.86 DE 3617045**

(43) Veröffentlichungstag der Anmeldung:
**25.11.87 Patentblatt 87/48**

(45) Bekanntmachung des Hinweises auf die
Patenterteilung:
**10.04.91 Patentblatt 91/15**

(84) Benannte Vertragsstaaten:
**DE FR IT NL**

(56) Entgegenhaltungen:
**US-A- 3 244 974**

**RADIO ENGINEERING & ELECTRONIC PHY-
SICS, Band 29, Nr. 2, 1984, Seiten 109-115,
Scripta Publishing Co., Silver Spring, Maryland, US; S.I. BONDARENKO et al.: "Thin film
SQUIDS for superconducting magnetic flux
measuring devices"**

**JOURNAL OF APPLIED PHYSICS, Band 53,
Nr. 11, 1982, Seiten 7592-7598, American Institute of Physics, New York, US; P. CARELLI
et al.: "Behavior of a multiloop dc superconducting quantum interference device"**

(73) Patentinhaber: **Siemens Aktiengesellschaft
Wittelsbacherplatz 2
W-8000 München 2(DE)**

(72) Erfinder: **Daalmans, Gabriel M., Dipl.-Ing.
Ungarnstrasse 11
W-8520 Erlangen(DE)**

## Beschreibung

Die Erfindung bezieht sich auf ein SQUID-Magnetometer in Dünnfilmtechnik für eine Vorrichtung zur Messung schwacher magnetischer Felder, wobei das Magnetometer

- ein Gleichstrom-SQUID mit einer die effektive Fläche eines Koppelloches umschließenden SQUID-Schleife

und

- einen supraleitenden Flußtransformator mit einer Gradiometerspule und einer das Koppelloch umschließenden Einkoppelspule zur induktiven Einkopplung eines Meßsignals in das SQUID

enthält.

Eine derartige Meßvorrichtung geht aus der Veröffentlichung "Radio Engineering & Electronic Physics", Vol.2, 1984, Seiten 109 bis 115 hervor.

Die Verwendung von supraleitenden Quanten-Interferometern, die auch als "SQUIDs" (Abkürzung von: "Superconducting QUantum Interference Devices") bezeichnet werden, zur Messung sehr schwacher magnetischer Felder ist allgemein bekannt ("J.Phys.E.: Sci.Instrum.", Vol. 13, 1980, Seiten 801 bis 813 oder "IEEE Transactions on Electron Devices", Vol. ED-27, No. 10, Okt. 1980, Seiten 1896 bis 1908). Als ein bevorzugtes Anwendungsgebiet für diese Interferometer wird deshalb auch die medizinische Technik, insbesondere die Magnetokardiographie und Magnetoenzephalographie angesehen, da die von magnetischen Herz- bzw. Gehirnwellen hervorgerufenen Magnetfelder Feldstärken in der Größenordnung von etwa 50 pT bzw. 0,1 pT hervorrufen ("Biomagnetism - Proceedings Third International Workshop on Biomagnetism, Berlin 1980", Berlin/New York 1981, Seiten 3 bis 31).

Zur Messung derartiger biomagnetischer Felder sind Meßvorrichtungen bekannt, die einkanalig und insbesondere auch mehrkanalig (vgl. z.B. die DE-A- 32 47 543) ausgeführt sein können. Diese Vorrichtungen enthalten je nach Anzahl der Kanäle mindestens ein SQUID-Magnetometer.

Ein derartiges, in Dünnfilmtechnik zu erstellendes Magnetometer geht aus der Literaturstelle "IEEE Transactions on Magnetics", Vol. MAG - 17, No. 1, Jan. 1981, Seiten 400 bis 403 hervor. Es weist eine verhältnismäßig breit gestaltete, ringförmige SQUID-Schleife aus supraleitendem Material auf, die einen quasi quadratischen oder rechteckigen Rahmen um ein entsprechend geformtes, zentrales Koppelloch bildet. Auf einer Seite ist diese Schleife durch einen schmalen nach außen führenden Schlitz vollständig unterbrochen, der fast vollständig von einer streifenförmigen Leiterbahn überlappt ist. In dem nicht-überlappten Bereich des Schlitzes wird die SQUID-Schleife über zwei für ein Gleichstrom-SQUID charakteristische Josephson-Tunnelelemente geschlossen. Auf dieser ringförmigen SQUID-Schleife befinden sich die das Koppelloch umschließenden, supraleitenden Windungen einer somit ebenfalls rahmenförmigen Einkoppelspule; d.h., bei dieser bekannten Ausführungsform dient die SQUID-Schleife auch als tragende Grundebene für die Einkoppelspule. Diese Einkoppelspule stellt zusammen mit mindestens einer an sie angeschlossenen supraleitenden Gradiometerspule einen Flußtransformator dar, mit dem ein zu detektierendes Meßsignal in das SQUID über die SQUID-Schleife einzukoppeln ist. Die Einkoppelverluste sind dabei proportional der Selbstinduktivität des Streifenleiters, der gebildet wird durch die Einkoppelspule und die SQUID-Schleife. Die Selbstinduktivät ist dabei durch die folgende Beziehung gegeben:

$$L = \mu_0 \cdot \frac{1 \cdot d_{ISO}}{W \cdot K}$$

Hierbei sind I die Länge der Einkoppelspule $d_{ISO}$ der Abstand zwischen der SQUID-Schleife und der Einkoppelspule, W die Spurbreite der Einkoppelspule und K der sogenannte Fringefaktor, der abhängt von $d_{ISO}/W$. Die Selbstinduktivität ist also eine Funktion von I und $d_{ISO}/W$. Sie ist um so niedriger, je kleiner der Quotient $d_{ISO}/W$ ist.

Es hat sich nun gezeigt, daß derartige Magnetometer, insbesondere für vielkanalige Meßvorrichtungen, nur sehr schwer mit befriedigenden Eigenschaften zu realisieren sind. Zum einen müssen nämlich die Abmessungen der SQUID-Schleife mindestens so groß gewählt werden, daß die Windungen der verhältnismäßig ausgedehnten Einkoppelspule auf diese Schleife aufzubringen sind. Entsprechend breite Streifen der Schleife beeinträchtigen dann jedoch ungünstig die Eigenschaften des SQUIDs. So sind unerwünschte Resonanzerscheinungen zwischen den geraden Leiterstücken der Windungen der Einkoppelspule und des darunterliegenden SQUIDs zu beobachten. Darüber hinaus ist eine parasitäre Induktivität an dem Schlitz der SQUID-Schleife verhältnismäßig groß. Wegen dieser parasitären Induktivität ist auch die Kopplung des magnetischen Flusses von der Einkoppelspule in das SQUID entsprechend erschwert.

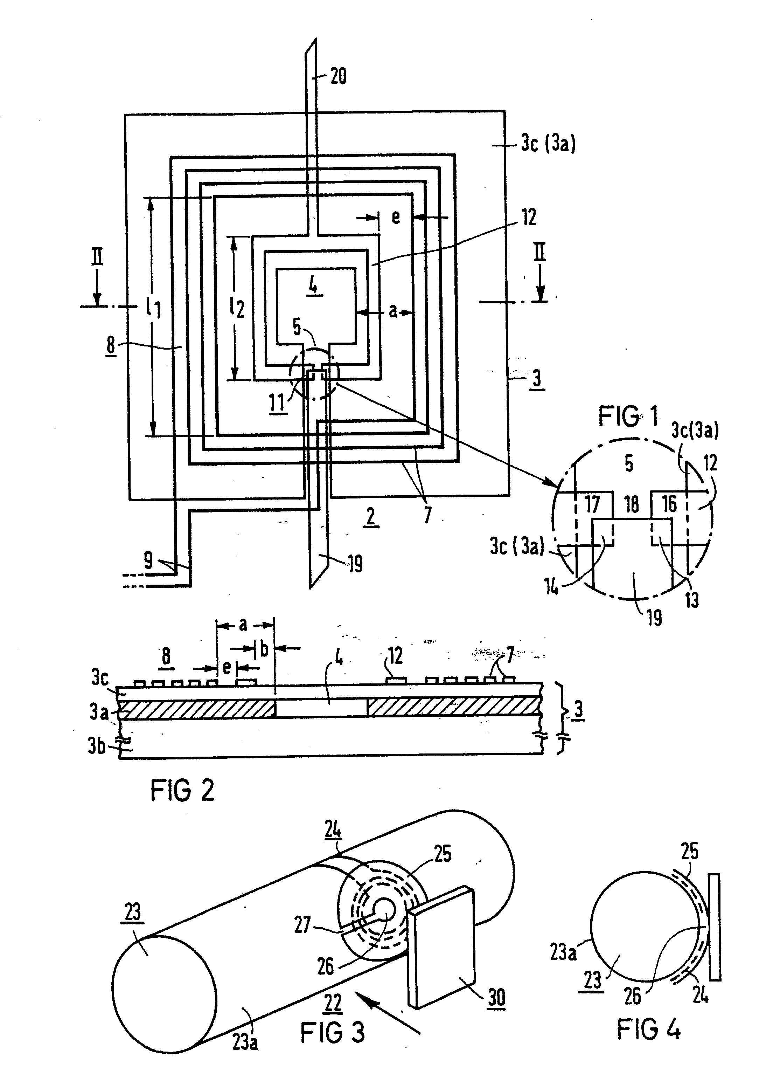

Entsprechende ungünstige Effekte treten auch bei einem aus der Veröffentlichung "Radio Engineering & Electronic Physics", Vol. 2, 1984, Seiten 109 bis 115 zu entnehmenden SQUID-Magnetometer auf (vgl. insbesondere fig. 3), das einen ähnlichen Aufbau wie das aus der genannten Veröffentlichung "IEEE Trans. Magn." bekannte Magnetometer zeigt. Auch bei diesem in Dünnfilmtechnik erstellten Magnetometer umschließt eine SQUID-Schleife einen als Koppelloch mit einer effektiven Fläche anzusehenden Bereich. Zur induktiven Einkopplung eines Meßsignals in diese Schleife dient auch hier eine von der Schleife überlappte Einkoppelspule. Das SQUID ist außerdem von einer besonderen, bei solchen Magnetometern üblichen supraleitenden Fläche abgedeckt, die als Abschirmung dient und eine Reduzierung der Induktanz des SQUIDs bewirkt.

Aufgabe der vorliegenden Erfindung ist es, das SQUID-Magnetometer der eingangs genannten Art dahingehend zu verbessern, daß die erwähnten ungünstigen Effekte zumindest weitgehend auf einfache Weise eliminiert sind.

Diese Aufgabe wird erfindungsgemäß dadurch gelöst, daß eine besondere durch einen seitlichen Schlitz unterbrochene supraleitende Koppelfläche mit dem Koppelloch vorgesehen ist, der die Einkoppelspule und/ oder die SQUID-Schleife zugeordnet sind/ist, wobei die Einkoppelspule die SQUID-Schleife unter Einhaltung eines hinreichenden Abstandes umschließt.

Überlappungsbereiche zwischen der Einkoppelspule und der SQUIDSchleife werden also zumindest weitgehend vermieden. Darüber hinaus ist vorteilhaft die unerwünschte Festlegung der Mindestausdehnung der SQUID-Schleife in Abhängigkeit von der Ausdehnung der Koppelspule aufgehoben; d.h., es sind nunmehr auch verhältnismäßig kleine SQUID-Schleifen in der für eine SQUID-Herstellung erforderlichen feinen Lithographie unabhängig von der verhältnismäßig groben Lithographie zur Ausbildung der Einkoppelspulen zu erstellen. Dabei wird die Induktivität des SQUIDs zumindest weitgehend nur durch die Induktivität des Koppelloches in der besonderen supraleitenden Fläche (Koppelfläche), nicht aber von den Abmessungen der Einkoppelspule bestimmt. Eine exakte Positionierung der SQUID-Schleife um dieses Koppelloch ist folglich nicht mehr erforderlich. Dies führt zu einer wesentlichen Erleichterung beim Aufbau des Magnetometers.

Dabei kann die SQUID-Schleife das Koppelloch unter Einhaltung eines gewissen Abstandes umschließen. Die effektive Fläche des Koppelloches ist dann gleich der tatsächlichen Koppellochfläche. Es ist jedoch auch möglich, daß eine im Randbereich des Koppelloches angeordnete SQUID-Schleife an ihrem Innenrandbereich ein Stückweit in das Koppelloch hineinragt, d.h. einen Randstreifen des Koppelloches abdeckt. In diesem Falle, in dem die effektive Fläche des Koppelloches kleiner als dessen tatsächliche Fläche ist, wird die Induktivität nicht durch das Koppelloch, sondern durch die Innenabmessungen der SQUID-Schleife bestimmt.

Vorteilhafte Ausgestaltungen des erfindungsgemäßen SQUID-Magnetometers gehen aus den Unteransprüchen hervor.

Zur weiteren Erläuterung der Erfindung wird nachfolgend auf die Zeichnung Bezug genommen, in deren Figuren 1 und 2 schematisch ein erfindungsgemäßes Magnetometer in zwei verschiedenen Ansichten angedeutet ist. Figuren 3 und 4 zeigen schematisch eine besondere Ausbildungsmöglichkeit eines weiteren Magnetometers in verschiedenen Ansichten.

Bei dem in Figur 1 in Aufsicht bzw. in Figur 2 als Querschnitt angedeuteten Teil eines allgemein mit 2 bezeichneten Magnetometers wird von Ausführungsformen in Dünnfilmtechnik ausgegangen, wie sie z.B. aus der genannten Literaturstelle "IEEE Trans.Magn." hervorgehen. Das Magnetometer dient insbesondere zum Aufbau von ein- oder mehrkanaligen Meßvorrichtungen vorzugsweise auf dem Gebiet der medizinischen Technik. Es soll in bekannter Dünnfilm-Technik herzustellen sein. Abweichend von den bekannten Ausführungsformen enthält das erfindungsgemäße Magnetometer 2 eine separate Fläche 3a eines Grundelementes 3. Diese im vorliegenden Fall als Grundfläche zu betrachtende Fläche 3a ist dabei auf einem beispielsweise aus Silizium bestehenden Substrat 3b aufgebracht. Sie wird von einer ringförmigen Schleife aus supraleitendem Material wie z.B. Niob gebildet und weist einen etwa quadratischen Umfang auf, so daß sich die Gestalt eines etwa quadratischen Rahmens ergibt. Diese Schleife umschließt ein zentrales, ebenfalls etwa quadratisches Koppelloch 4. Sie ist ferner an einer Seite durch einen schmalen von dem Koppelloch nach außen führenden Spalt oder Schlitz 5 völlig unterbrochen. Die Grundfläche 3a ist in bekannter Weise mit einer galvanischen Trennschicht 3c überzogen. Auf dieser z.B. aus SiO oder SiO$_2$ bestehenden Schicht 3c sind die das Koppelloch 4 in einem verhältnismäßig großen Abstand a umschließenden Windungen 7 einer an sich bekannten Einkoppelspule 8 angeordnet. Die Anzahl der z.B. rechteckige, insbesondere etwa quadratische Schleifen ausbildenden Windungen ist im allgemeinen wesentlich größer ist als in Figur 1 ausgeführt. An den aus dem Bereich der Grundfläche 3a herausgeführten Enden 9 dieser Einkoppelspule 8 ist die mindestens eine Schleife eines bekannten, in der Figur nicht dargestellten Gradiometers angeschlossen. Zusammen mit diesem Gradiometer bildet die Einkoppelspule 8 einen sogenannten supraleitenden Flußtransformator. Über diesen Flußtransformator und die besondere supraleitende Fläche 3a ist ein mit der mindestens einen Gradiometerschleife zu detektierendes magnetisches Signal induktiv in ein Gleichstrom-SQUID 11 einzukoppeln. Die supraleitende Fläche 3a kann deshalb auch als Koppelfläche bezeichnet werden. Das SQUID 11 kann vorteilhaft so ausgebildet werden, daß es eine kleine Selbstinduktivität hat. Hierzu setzt es sich im wesentlichen aus einer das Koppelloch 4 mit einer verhältnismäßig kleinen Beabstandung b umschließenden, etwa quadratischen SQUID-Schleife 12 und zwei Josephson-Kontakten (-Elementen) 13 und 14 zusammen. Diese in Figur 1 gezeichnete SQUID-Schleife 12 ist dabei im Bereich des Schlitzes 5 der Grundfläche 3a ebenfalls geschlitzt. Die entsprechende Trennzone zwischen den somit beabstandeten, einander gegenüberliegenden Enden 16 und 17 der SQUID-Schleife 12 ist in dem vergrößerten Teil der Figur 1 mit 18 bezeichnet. Durch den Bereich des Schlitzes 5 der Grundfläche 3a erstreckt sich ferner ein SQUID-Anschlußleiter 19 mit hinreichender Breite, so daß dieser die beiden gegenüberliegenden Enden 16 und 17 der SQUID-Schleife 12 teilweise überlappt. In den entsprechenden Überlappungsbereichen sind die beiden Josephson-Kontakte 13 und 14 ausgebildet. Auf der dem Anschlußleiter 19 bzw. dem Schlitzbereich 5 gegenüberliegenden Seite der SQUID-Schleife 12 ist ein weiterer aus dem Bereich der Grundfläche 3a nach außen führender Anschlußleiter 20 vorgesehen. Beide Anschlußleiter können über die oder unter den Windungen 7 der Einkoppelspule 8 hindurchführen. Auf eine zeichnerische Darstellung weiterer, das SQUID 11 und die Einkoppelspule 8 abdeckender Schichten wurde in Figur 2 aus Gründen der Übersichtlichkeit verzichtet.

Die Positionierung der SQUID-Schleife 12 bezüglich des Koppelloches 4 ist vorteilhaft nicht besonders kritisch, da die Koppelung der Einkoppelspule 8 an das SQUID 11 über die von diesen Bauteilen galvanisch getrennte Grund- oder Koppelfläche 3a mit dem Koppelloch 4 erfolgt. Auf diese Art und Weise ist zwar die Einkoppelspule 8 magnetisch stark an das SQUID 11 gekoppelt. Dabei läßt sich jedoch vorteilhaft eine unmittelbare Kopplung der Spule 8 und der SQUID-Schleife 12 zumindest weitgehend vermeiden, indem diese Teile sich nicht wie bei der Ausführungsform gemäß der genannten Literaturstelle "IEEE Trans.Magn." überlappen, sondern erfindungsgemäß räumlich voneinander hinreichend getrennt sind. Die Innenabmessungen $l_1$ der Einkoppelspule 8 sind also größdser als die Außenabmessungen $l_2$ der SQUID-Schleife 12, wobei zwischen den Windungen 7 der Einkoppelspule und der SQUID-Schleife eine hinreichende Entfernung e eingehalten ist.

Gemäß dem in den Figuren 1 und 2 gezeigten Ausführungsbeispiel wurde von einem rechteckigen, insbesondere etwa quadratischen Koppelloch 4 ausgegangen, dessen Form eine entsprechende Gestalt der supraleitenden Grundfläche 3a, der SQUID-Schleife 12 und der Einkoppelspule 8 mit sich bringt. Für die Teile 3a, 4, 12 und 8 lassen sich jedoch ebensogut auch andere Formen vorsehen, wobei diese Teile untereinander auch verschiedene Gestalt haben können. So kann z.B. ein etwa kreisförmiges Koppelloch in einer etwa kreisringförmigen Grundfläche von einer etwa quadratischen SQUID-Schleife und/oder einer etwa quadratischen Einkoppelspule umschlossen sein.

Ferner braucht die SQUID-Schleife 12 auch nicht so groß ausgebildet zu sein, daß zwischen ihrem dem Koppelloch 4 zugewandten Innenrand und dem jeweiligen Koppellochrand die geringe Beabstandung b vorhanden ist. Vielmehr sind auch kleinere Innenabmessungen der SQUID-Schleife möglich. So kann man auch SQUID-Schleifen vorsehen, deren Innenabmessungen so klein sind, daß sie einen Randbereich des Koppelloches 4 abdekken.

Wie aus Figur 2 deutlich zu entnehmen ist, sind bei der gewählten Ausführungsform das Gleichstrom-SQUID 11 sowie die Windungen der Einkoppelspule 8 unmittelbar auf der die Grundfläche 3a abdeckenden Trennschicht 3c angeordnet. Aufgrund der erfindungsgemäßen Verwendung dieser besonderen Grundfläche 3a ist es jedoch auch möglich, auf ihr als einziges Bauteil nur die Einkoppelspule oder nur die SQUID-Schleife aufzubringen, während für das andere, somit nicht auf der Grundfläche befindliche Bauteil ein weiteres Trägerelement vorzusehen ist. Diese zunächst getrennt vorzufertigenden Teile sind dann mechanisch, beispielsweise durch Verkleben oder Anklemmen, so aneinanderzufügen, daß sich eine Anordnung ergibt, die der in Figur 1 ersichtlichen Anordnung von Koppelspule und SQUID-Schleife in etwa entspricht. Ein Ausführungsbeispiel hierfür ist in den Figuren 3 und 4 angedeutet. Dabei stellt Figur 3 eine Schrägansicht auf einen Teil eines allgemein mit 22 bezeichneten Magnetometers dar, während aus Figur 4 ein Querschnitt durch diesen Teil ersichtlich ist. Gemäß dem dargestellten Ausführungsbeispiel befinden sich dabei auf der äußeren Mantelfläche 23a eines zylinderförmigen Grundelementes 23 die mehreren Windungen einer somit entsprechend gekrümmten, etwa kreisförmigen Einkoppelspule 24 . Diese Einkoppelspule ist von einer besonderen supraleitenden Fläche 25 mit einem zentralen kreisförmigen Koppelloch 26 und einem seitlichen Schlitz 27 abgedeckt, wobei eine galvanische Trennung zwischen der Einkoppelspule 24 und der Deck- oder Koppelfläche 25 gewährleistet ist. Gegebenenfalls können auf der Mantelfläche 23a auch zunächst die Koppelfläche 25 und darauf die Einkoppelspule 24 aufgebracht sein. Ein in den Figuren nicht ersichtliches Gleichstrom-SQUID mit einer SQUID-Schleife, deren Abmessungen der Größe des Koppelloches 26 angepaßt ist, befindet sich auf einem eigenen, ebenen Trägerelement, beispielsweise einem Silizium-Substrat. Der entsprechende SQUID-Chip ist in den Figuren allgemein mit 30 bezeichnet. Nach der Erfindung ist es also vorteilhaft möglich, ein planares SQUID an eine sich auf einer gekrümmten Fläche befindliche und somit selbstgekrümmte Einkoppelspule ohne weiteres anzukoppeln.

Gemäß den Figuren 3 und 4 wurde davon ausgegangen, daß die supraleitende Koppelfläche 25 der Einkoppelspule 24 zugeordnet ist. Dies ist im Falle einer gekrümmten Gestalt der Einkoppelspule besonders vorteilhaft. Im Falle der Verwendung von nicht-gekrümmten Substratträgern ist auch eine Zuordnung der supraleitenden Koppelfläche zu der SQUID-Schleife möglich.

**Ansprüche**

1. SQUID-Magnetometer (2 ) in Dünnfilmtechnik für eine Vorrichtung zur Messung schwacher magnetischer Felder, wobei das Magnetometer (2 )
   - ein Gleichstrom-SQUID (11 ) mit einer die effektive Fläche eines Koppelloches (4; 26) umschließenden SQUID-Schleife (12) und
   - einen supraleitenden Flußtransformator mit einer Gradiometerspule und einer das Koppelloch (4; 26) umschließenden Einkoppelspule (8 ; 24 ) zur induktiven Einkopplung eines Meßsignals in das SQUID (11 ) enthält, **dadurch gekennzeichnet,** daß eine besondere durch einen seitlichen Schlitz (5; 27) unterbrochene supraleitende Koppelfläche (3a, 3c; 25) mit dem Koppelloch (4; 26) vorgesehen ist, der die Einkoppelspule koppelspule (8 ; 24 ) und/oder die SQUID-Schleife (12) zugeordnet sind/ist, wobei die Einkoppelspule (8 ; 24 ) die SQUID-Schleife (12) unter Einhaltung eines hinreichenden Abstandes (e) umschließt.

2. SQUID-Magnetometer nach Anspruch 1, **dadurch gekennzeichnet,** daß die SQUID-Schleife (12) das Koppelloch (4) unter Einhaltung einer gegenseitigen Beabstandung (b) umschließt.

3. SQUID-Magnetometer nach Anspruch 1, **dadurch gekennzeichnet,** daß die Innenabmessungen der SQUID-Schleife zumindest teilweise kleiner als die entsprechenden Abmessungen des Koppelloches sind, so daß die SQUID-Schleife das Koppelloch entsprechend zum Teil abdeckt.

4. SQUID-Magnetometer nach einem der Ansprüche 1 bis 3, **dadurch gekennzeichnet,** daß auf der supraleitenden Koppelfläche (3a) galvanisch von dieser getrennt das SQUID (11 ) und die Einkoppelspule (8 ) angeordnet sind (Figuren 1 und 2).

5. SQUID-Magnetometer nach einem der Ansprüche 1 bis 3, **dadurch gekennzeichnet,** daß der supraleitenden Fläche (25) mit dem Koppelloch (26) als einziges Bauteil nur die Einkoppelspule (24 ) oder das SQUID mit seiner SQUID-Schleife zugeordnet ist, während für das andere, dieser supraleitenden Fläche (25) nicht zugeordnete Bauteil ein weiteres Trägerelement (SQUID-Chip 30 ) vorgesehen ist, und daß diese Bauteile zumindest weitgehend zentrisch bezüglich des Koppelloches (26) aneinandergefügt sind (Figuren 3 und 4).

6. SQUID-Magnetometer nach Anspruch 5, **dadurch gekennzeichnet,** daß die Einkoppelspule (24 ) auf einer gekrümmten Fläche (23a) aufgebracht und von der supraleitenden Fläche (25) mit dem Koppelloch (26) abgedeckt ist.

**Claims**

1. A thin film SQUID magnetometer (2 ) for a device for measuring weak magnetic fields, wherein the magnetometer (2 ) contains
   - a direct current SQUID (11 ) with a SQUID loop (12) surrounding the effective surface of a coupling hole (4; 26) and
   - a superconducting flux transformer with a gradiometer coil and a coupling coil (8 ; 24 ) surrounding the coupling hole (4; 26) for the inductive coupling of a measurement signal into the SQUID (11 ), characterized in that a special superconducting coupling area (3a, 3c; 25), interrupted by a lateral slot (5; 27), is provided with the coupling hole (4; 26) to which the coupling coil (8 ; 24 ) and/or the SQUID loop (12) are/is assigned, with the coupling coil (8 ; 24 ) surrounding the SQUID loop (12) while maintaining a sufficient distance (e).

2. SQUID magnetometer according to claim 1, characterized in that the SQUID loop (12) surrounds the coupling hole (4) while maintaining a mutual distance (b).

3. SQUID magnetometer according to claim 1, characterized in that the internal dimensions of the SQUID loop are at least partially smaller than the corresponding dimensions of the coupling hole so that the SQUID loop accordingly partially covers the coupling hole.

4. SQUID magnetometer according to one of claims 1 to 3, characterized in that the SQUID (11 ) and the coupling coil (8 ) are disposed on the superconducting coupling area (3a) galvanically separated from it (Figures 1 and 2).

5. SQUID magnetometer according to one of claims 1 to 3, characterized in that the coupling coil (24 ) or the SQUID with its SQUID loop is the only component associated with the superconducting coupling area (25) with the coupling hole (26), whilst for the other component not associated with this superconducting coupling area (25) there is provided a further carrier element (SQUID chip 30 ), and in that these components are joined together at least substantially centrally with respect to the coupling hole (26) (Figures 3 and 4).

6. SQUID magnetometer according to claim 5, characterized in that the coupling coil (24 ) is disposed on a curved surface (23a) and is covered by the superconducting coupling area (25) with the coupling hole (26).

**Revendications**

1. Magnétomètre à SQUID (2 ) réalisé selon la technique des couches minces pour un dispositif servant à mesurer des champs magnétiques faibles, le magnétomètre (2 ) comportant
   - un SQUID à courant continu (11) possédant une boucle (12) du SQUID entourant la surface efficace d'un trou de couplage (4;26), et
   - un transformateur de flux supraconducteur possédant une bobine de gradiomètre et une bobine de couplage (8 ; 24 ), qui entoure le trou de couplage (4;26) et sert à réaliser l'introduction, par couplage inductif, d'un signal de mesure dans le SQUID (11), caractérisé par le fait qu'il est prévu une surface supraconductrice de couplage particulière (3a,3c;25), interrompue notamment par une fente latérale (5;27) et comportant le trou de couplage (4;26) et à laquelle est associée la bobine de couplage (8 ;24 ) et/ou la boucle (12) du SQUID, la bobine de couplage (8 ;24 ) entourant la boucle (12) du SQUID en en étant séparée par une distance (e) suffisante.

2. Magnétomètre à SQUID suivant la revendication 1, caractérisé par le fait que la boucle (12) du SQUID entoure le trou de couplage (4) en en étant séparée par une distance (b).

3. Magnétomètre à SQUID suivant la revendication 1, caractérisé par le fait que les dimensions intérieures de la boucle du SQUID sont au moins en partie inférieures aux dimensions correspondantes du trou de couplage, en sorte que la boucle du SQUID recouvre en partie, de façon correspondante, le trou de couplage.

4. Magnétomètre à SQUID suivant l'une des revendications 1 à 3, caractérisé par le fait que le SQUID (11 ) et la bobine de couplage (8 ) sont disposés sur la surface supraconductrice de couplage (3a), en en étant séparés galvaniquement (figures 1 et 2).

5. Magnétomètre à SQUID suivant l'une des revendications 1 à 3, caractérisé par le fait qu'à la surface supraconductrice (25) comportant le trou de couplage (26) est associée, en tant que composant unique, seule la bobine de couplage (24 ) ou le SQUID équipé de sa boucle, tandis que pour l'autre composant non associé à cette surface supraconductrice de couplage (25), il est prévu un autre élément de support (microplaquette 30 du SQUID), et que ces composants sont réunis en étant centrés, au moins dans une large mesure, par rapport au trou de couplage (26) (figures 3 et 4).

6. Magnétomètre à SQUID suivant la revendication 5, caractérisé par le fait que la bobine de couplage (24 ) est installée sur une surface courbe (23a) et est recouverte par la surface supraconductrice de couplage (25) qui comporte le trou de couplage (26).

FIG 1

FIG 2

FIG 3

FIG 4